# EUROPEAN PATENT APPLICATION

(11) **EP 4 036 989 A1**
(43) Date of publication of application: **03.08.2022**
(21) Application number: 22151121.5
(22) Date of filing: 12.01.2022
(51) Int. Cl.: H01L 29/78, H01L 21/336

(54) **SEMICONDUCTOR DEVICE AND METHOD OF FORMING THE SAME**

(30) Priority: 28.01.2021 US 202163142518 P; 23.12.2021 US 202117560496
(71) Applicant: MediaTek Inc., Hsinchu City 30078 (TW)
(72) Inventor: LIN, Cheng-Hua, 30078 Hsinchu City (TW); JI, Yan-Liang, 30078 Hsinchu City (TW); JAN, Ching-Han, 30078 Hsinchu City (TW)
(74) Representative: Goddar, Heinz J.

(57) **Abstract**

A semiconductor device includes a semiconductor substrate having a well region and a gate structure formed over the well region of the semiconductor substrate. The gate structure has a first sidewall and a second sidewall. The second sidewall is opposite the first sidewall. The semiconductor device also includes a gate spacer structure having two asymmetrical portions. One of the asymmetrical portions is formed on the first sidewall of the gate structure, and the other asymmetrical portion is formed on the second sidewall of the gate structure. The semiconductor device includes a source region and a drain region formed in the semiconductor substrate and aligned with the outer edges of the asymmetrical portions of the gate spacer structure. In some embodiments, the lateral distance between the drain region and the gate structure is greater than the lateral distance between the source region and the gate structure.

## Description

### CROSS REFERENCE TO RELATED APPLICATIONS

This Application is based on, and claims priority of U.S. Provisional Application No. 63/142,518 filed on January 28, 2021, the entirety of which is incorporated by reference herein.

### BACKGROUND OF THE INVENTION

### Field of the Invention

The present invention relates to a semiconductor device and a method of forming the same, and in particular to a semiconductor device having asymmetrical gate spacers to improve electrical performance and a method of forming the same.

### Description of the Related Art

In recent years, as demand has increased for high-voltage devices, there has been an increasing interest in research on high-voltage metal-oxide-semiconductor (MOS) transistors applied in high-voltage devices. The high-voltage (HV) MOS devices for use under high voltages, which may be, but not limited to, voltages higher than the voltage supplied to the I/O circuit. MOS devices such as HVMOS devices may function as switches and are broadly utilized in audio output drivers, CPU power supplies, power management systems, AC/DC converters, LCD or plasma television drivers, automobile electronic components, PC peripheral devices, small DC motor controllers, and other consumer electronic devices.

Although existing semiconductor devices such as MOS devices and methods of forming the same have been adequate for their intended purposes, they have not been entirely satisfactory in all respects. For example, when the semiconductor devices have been scaled down in size, the complexity of processing and manufacturing the semiconductor devices has been increased. As semiconductor devices scale to smaller sizes, lateral distances between the electrodes are reduced, which may cause considerable effects on electrical performances of the semiconductor devices. Also, with progress being made in semiconductor fabrication, the breakdown voltage of high-voltage MOS devices needs to be increased further to meet device performance requirements as the needs in semiconductor fabrication of high-voltage devices continue. Therefore, there are still some problems to be overcome in regards to semiconductor devices in the semiconductor integrated circuits and technology.

### BRIEF SUMMARY OF THE INVENTION

Some embodiments of the present disclosure provide semiconductor devices. An exemplary embodiment of a semiconductor device includes a semiconductor substrate having a well region and a gate structure formed over the well region of the semiconductor substrate. In some embodiments, the gate structure has a first sidewall and a second sidewall. The second sidewall is opposite the first sidewall. The semiconductor device also includes a gate spacer structure having two asymmetrical portions. In some embodiments, the asymmetrical portions are formed on the first sidewall and the second sidewall of the gate structure, respectively. The semiconductor device also includes a source region and a drain region formed in the semiconductor substrate. The outer edges of the source region and the drain region are aligned with the outer edges of the asymmetrical portions of the gate spacer structure. In some embodiments, the lateral distance between the drain region and the gate structure is greater than the lateral distance between the source region and the gate structure.

Some embodiments of the present disclosure provide a method of forming a semiconductor device. First, a semiconductor substrate having a well region and an isolation structure adjacent to the well region is provided. Also, a gate structure is formed over the well region of the semiconductor substrate, wherein the gate structure has a first sidewall and a second sidewall. The second sidewall is opposite the first sidewall. The method of forming the semiconductor device also includes forming a gate spacer structure having two asymmetrical portions respectively overlying the first sidewall and the second sidewall of the gate structure. The method of forming the semiconductor device further includes forming a source region and a drain region in the semiconductor substrate. The source region and the drain region are aligned with outer edges of the asymmetrical portions of the gate spacer structure. In some embodiments, the lateral distance between the drain region and the gate structure is greater than the lateral distance between the source region and the gate structure.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1A, FIG. 1B, FIG. 1C, FIG. 1D, FIG. 1E, FIG. 1F and FIG. 1G are cross-sectional views of intermediate stages of a method of forming a semiconductor device, in accordance with some embodiments of the present disclosure.
FIG. 2A, FIG. 2B, FIG. 2C, FIG. 2D, FIG. 2E, FIG. 2F and FIG. 2G are cross-sectional views of intermediate stages of another method of forming a semiconductor device, in accordance with some embodiments of the present disclosure.
FIG. 3 is a cross-sectional view of an intermediate stage of a semiconductor device, in accordance with some embodiments of the present disclosure.
FIG. 4 is a cross-sectional view of an intermediate stage of a semiconductor device, in accordance with some embodiments of the present disclosure.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is determined by reference to the appended claims.

The inventive concept is described fully hereinafter with reference to the accompanying drawings, in which exemplary embodiments of the inventive concept are shown. The advantages and features of the inventive concept and methods of achieving them will be apparent from the following exemplary embodiments that will be described in more detail with reference to the accompanying drawings. It should be noted, however, that the inventive concept is not limited to the following exemplary embodiments, and may be implemented in various forms. Accordingly, the exemplary embodiments are provided only to disclose the inventive concept and let those skilled in the art know the category of the inventive concept. Also, the drawings as illustrated are only schematic and are non-limiting. In the drawings, the size of some of the elements may be exaggerated for illustrative purposes and not drawn to scale. The dimensions and the relative dimensions do not correspond to actual dimensions in the practice of the invention.

The terminology used herein is for the purpose of describing particular embodiments only and is not intended to limit the invention. As used herein, the singular terms "a," "an" and "the" are intended to include the plural forms as well, unless the context clearly indicates otherwise. As used herein, the term "and/or" includes any and all combinations of one or more of the associated listed items. It should be understood that when an element is referred to as being "connected" or "contacting" to another element, it may be directly connected to or contacting the other element, or intervening elements may be present.

Similarly, it should be understood that when an element such as a layer, region or substrate is referred to as being "on" another element, it can be directly on the other element or intervening elements may be present. In contrast, the term "directly" means that there are no intervening elements. It should be understood that the terms "comprises", "comprising", "includes" and/or "including", when used herein, specify the presence of stated features, integers, steps, operations, elements, and/or components, but do not preclude the presence or addition of one or more other features, integers, steps, operations, elements, components, and/or groups thereof.

Furthermore, spatially relative terms, such as "beneath," "below," "above," "upper" and the like, may be used herein for ease of description to describe one element or feature's relationship to another element(s) or feature(s) as illustrated in figures. The spatially relative terms are intended to encompass different orientations of the device in use or operation in addition to the orientation depicted in the figures. It should be understood that although the terms first, second, third etc. may be used herein to describe various elements, these elements should not be limited by these terms. These terms are only used to distinguish one element from another element. Thus, a first element in some embodiments could be termed a second element in other embodiments without departing from the teachings of the present invention. Exemplary embodiments of aspects of the present inventive concept explained and illustrated herein include their complementary counterparts. The same or similar reference numerals or reference designators denote the same or similar elements throughout the specification.

Some embodiments of the disclosure are described. It should be noted that additional procedures can be provided before, during, and/or after the stages described in these embodiments. Some of the stages that are described can be replaced or eliminated for different embodiments. Additional features can be added to the semiconductor device structure. Some of the features described below can be replaced or eliminated for different embodiments. Although some embodiments are discussed with procedures performed in a particular order, these procedures may be performed in another logical order.

According to some embodiments of the present disclosure, a semiconductor device and a method of forming the same are described below, wherein a gate spacer structure having two asymmetrical portions is formed for extending the distance between a drain region and a gate structure of the semiconductor device. In some embodiments, a semiconductor device includes a semiconductor substrate having a well region, a gate structure formed over the well region of the semiconductor substrate, a gate spacer structure comprising two asymmetrical portions respectively overlying opposite sidewalls (e.g. the first sidewall and the second sidewall described in the embodiments below) of the gate structure, a source region and a drain region formed in the semiconductor substrate and aligned respectively with outer edges of the asymmetrical portions of the gate spacer structure, wherein the lateral distance between the drain region and the gate structure is greater than the lateral distance between the source region and the gate structure. The electrical performances of the semiconductor device in accordance with some embodiments of the present disclosure can be significantly improved. For example, a safe operating area (SOA) diagram defines the maximum values of drain-source voltage (V_{DS}) and drain current (I_{D}) for correct functioning of a semiconductor device, such as a metal-oxide semiconductor field-effect transistor (MOSFET). In some embodiments, the extended distance between the drain region and the gate structure of the semiconductor device increases the breakdown voltage and the zone of the safe operating area (SOA). Also, the extended distance between the drain region and the gate structure of the semiconductor device reduces the undesirable parasite capacitance between the gate structure and a drain contact plug that is connected to the drain region. In addition, more current is allowed to flow from the source to the drain terminal when the lateral distance between the source region and the gate structure is less than the lateral distance between the drain region and the gate structure of the semiconductor device, in accordance with some embodiments of the present disclosure.

Some of the methods of forming the semiconductor device in accordance with some embodiments of the present disclosure are provided below. It should be noted that the present disclosure is not limited to the exemplified methods and structures described herein. Those steps and structures described below are merely for providing examples of the fabrication and configuration of the semiconductor device.

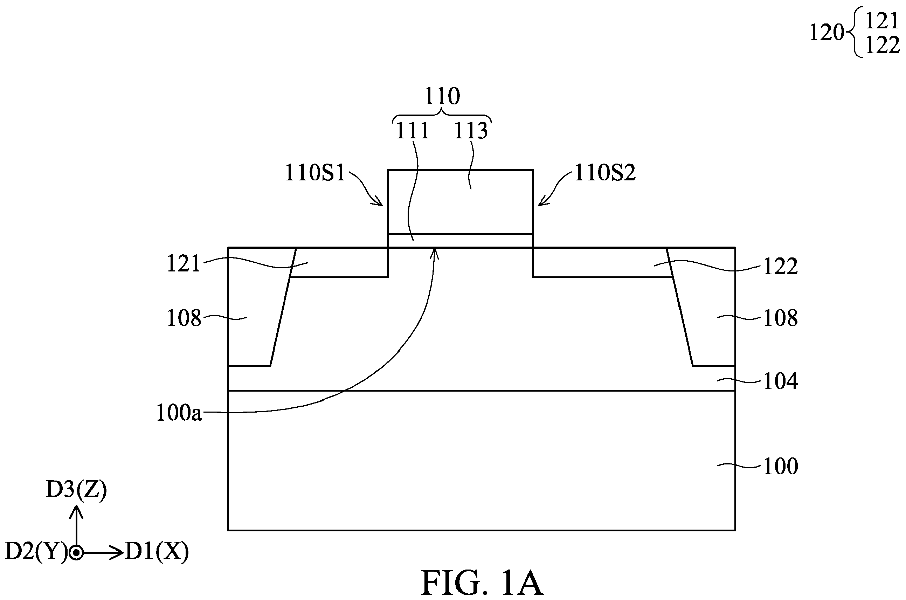

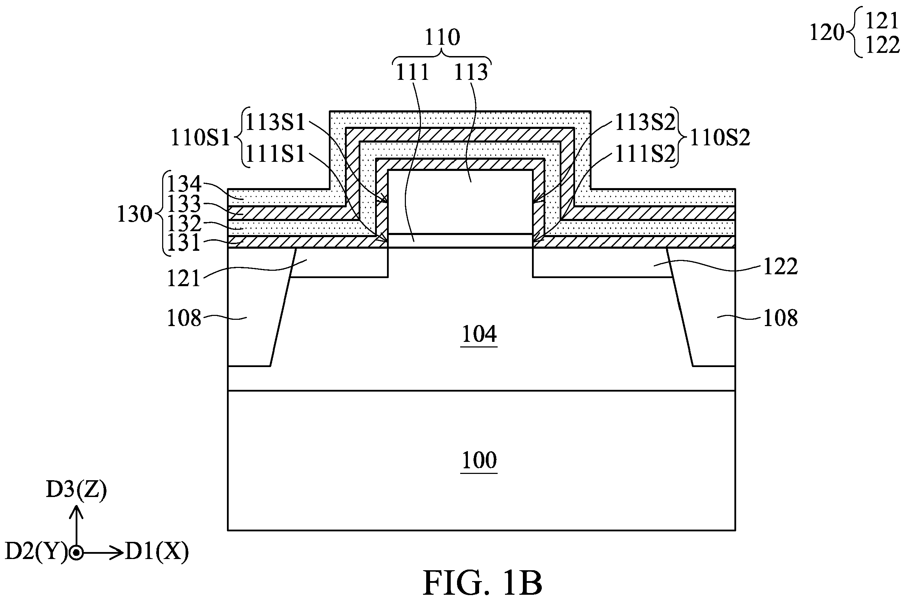

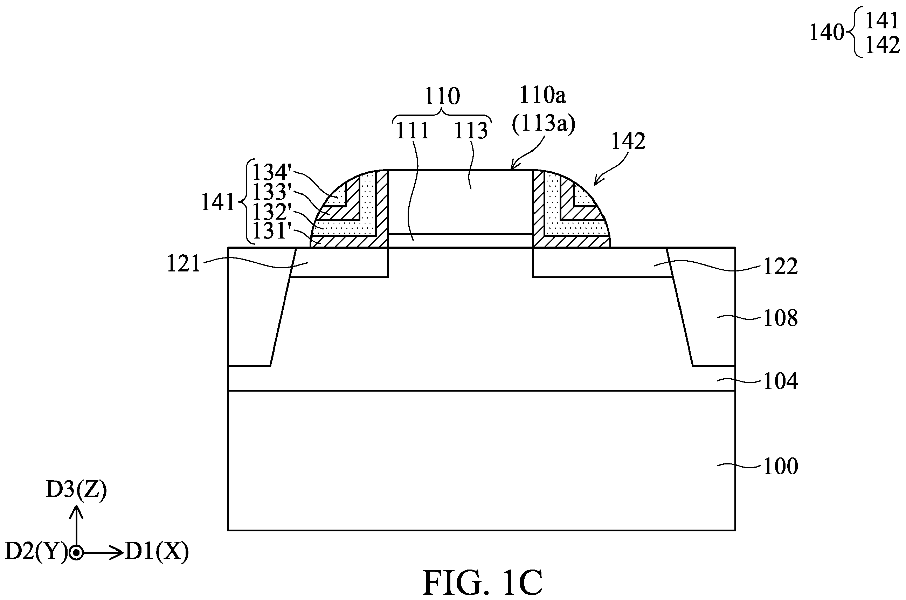

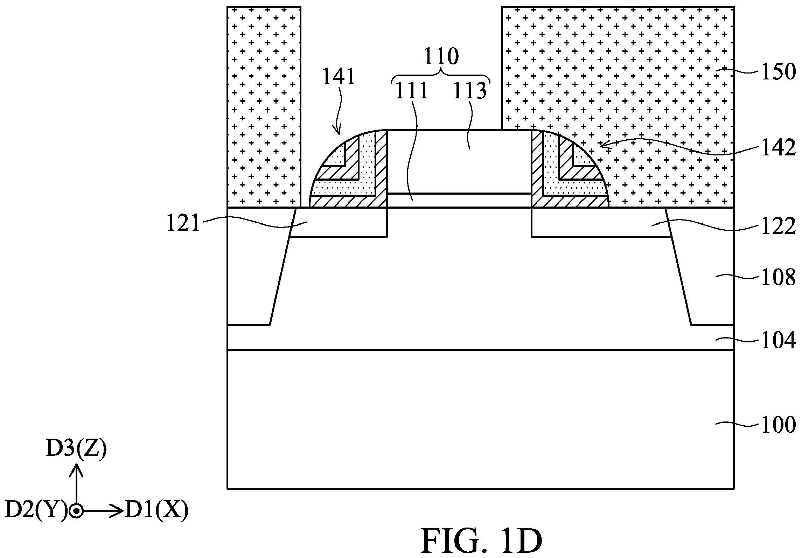

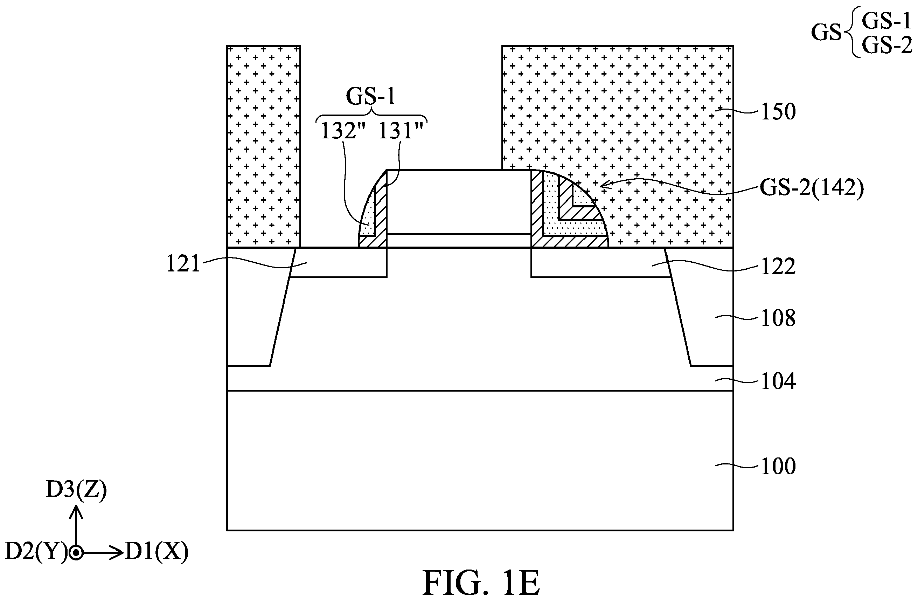

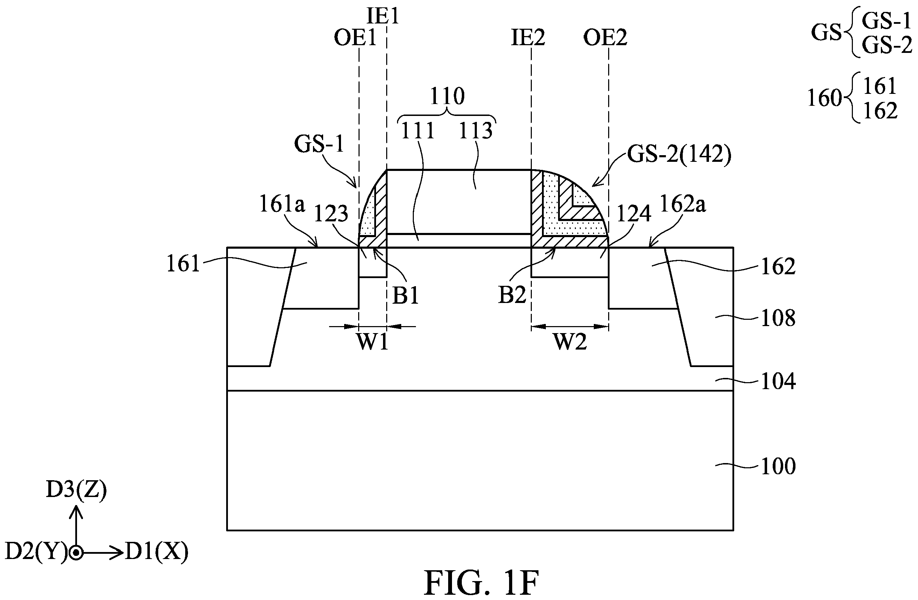

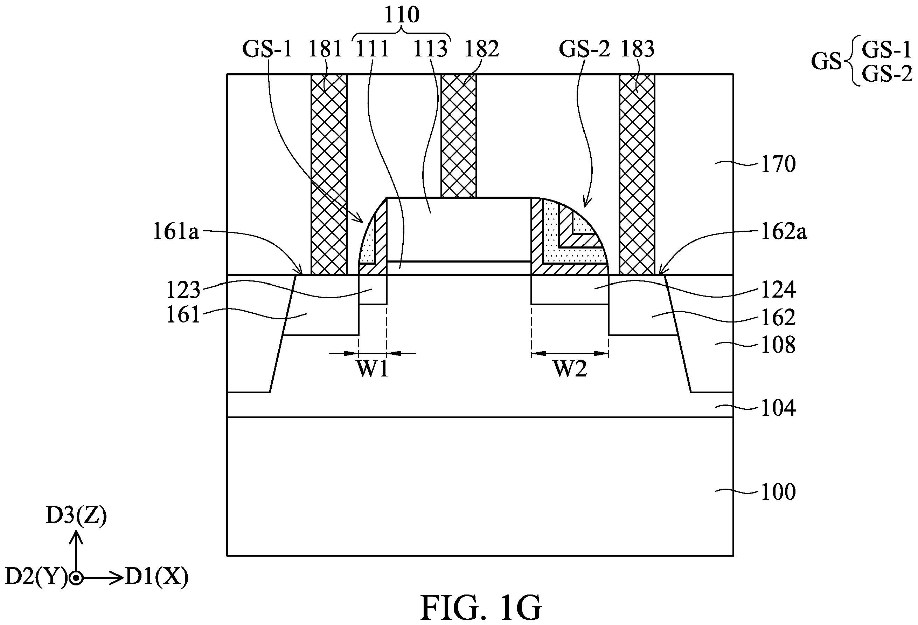

FIG. 1A, FIG. 1B, FIG. 1C, FIG. 1D, FIG. 1E, FIG. 1F and FIG. 1G are cross-sectional views of intermediate stages of a method of forming a semiconductor device, in accordance with some embodiments of the present disclosure. To simplify the diagram, only a single transistor is depicted herein. However, the number of the transistors is not limited thereto.

Referring to FIG. 1A, a semiconductor substrate 100 with a well region 104 and an isolation structure 108 adjacent to the well region 104 is provided. Also, a gate structure 110 is formed over the well region 104 of the semiconductor substrate 100. In some embodiments, the semiconductor substrate 100 is a silicon substrate. The semiconductor substrate 100 may have a first conductivity type such as P-type. The well region 104 is formed in the semiconductor substrate 100 and may have the second conductive type, for example N-type.

Although only the well region 104 is depicted in the semiconductor substrate 100 for the purpose of brevity, the semiconductor substrate 100 may further include other features such as other well regions. For example, the semiconductor substrate 100 may further include a deep well region (not shown) having a second conductive type that is the opposite of the first conductivity type, for example N-type. Also, the semiconductor substrate 100 may further include a well region (not shown) having a first conductivity type such as P-type (referred to as a P-well region) formed in the deep well region, wherein a portion of the P-well region extends between the deep well region and the well region 104. The well region 104 may be formed within the P-well region and surrounded by the isolation structure 108 and the P-well region.

As shown in FIG. 1A, the isolation structure 108 that extends downward from the upper surface 100a of the semiconductor substrate 100 is embedded in the semiconductor substrate 100. In some embodiments, the isolation structure 108 includes shallow trench isolation (STI) elements. In some embodiments, the isolation structure 108 includes field oxide (FOX) isolation elements. The isolation structure 108 may include silicon oxide, another suitable insulating material, or a combination thereof.

In some embodiments, the gate structure 110 is formed on the upper surface 100a of the semiconductor substrate 100 and over the well region 104 of the semiconductor substrate 100. The gate structure 110 may include a gate dielectric layer 111 and a conductive layer 113 on the gate dielectric layer 111. The gate structure 110 may be formed by a photolithography process for patterning the material layers of the gate dielectric layer 111 and the conductive layer 113. Although only one gate structure 110 of a transistor is depicted in the drawings, several gate structures 110 of the transistors may be formed in the application, and those gate structures 110 may be spaced apart from each other in the first direction D1 (such as X-direction). In addition, in some embodiments, the gate structure 110 extends in the second direction D2 (such as Y-direction).

The gate dielectric layer 111 may be a single layer or a multi-layered structure. In some embodiments, the gate dielectric layer 111 is a silicon oxide layer. In some embodiments, the gate dielectric layer 111 is formed of oxides, oxynitrides, nitrides, high-k materials, other suitable materials, and a combination thereof. In one example, the gate dielectric layer 111 may include an interfacial layer (not shown) and a high-k dielectric layer formed on the interfacial layer. The interfacial layer, the high-k dielectric layer and the conductive layer 113 are stacked in the third direction D3 (such as Z- direction). For example, the interfacial layer may be formed on the semiconductor substrate 100 and include a silicon oxide layer. The high-k dielectric layer may be formed on the interfacial layer by atomic layer deposition (ALD) or other suitable technique. The conductive layer 113 may be formed on the high-k dielectric layer. The high-k dielectric layer may include hafnium oxide (HfO₂). Alternatively, the high-k dielectric layer may optionally include other high-k dielectrics such as hafnium silicon oxide (HfSiO), hafnium silicon oxynitride (HfSiON), hafnium tantalum oxide (HfTaO), hafnium titanium oxide (HfTiO), hafnium zirconium oxide (HfZrO), and combinations thereof. It should be noted that the gate dielectric layer 111 of the present disclosure is not limited to include the aforementioned materials.

The conductive layer 113 of the gate structure 110 can be referred to as a gate electrode. In some embodiments, the conductive layer 113 includes polysilicon, metal, metal silicide, metal nitride, another suitable material, and a combination thereof. Exemplified metal materials of the conductive layer 113 include TiN, TaN, ZrSi₂, MoSi₂, TaSi₂, NiSi₂, WN, or another suitable metal material. Also, in some embodiments, the conductive layer 113 is formed of polysilicon, such as doped polysilicon. The conductive layer 113 of the gate structure 110 can be formed by a deposition method, such as chemical vapor deposition (CVD), physical vapor deposition (PVD), sputtering, plating, or another suitable method.

In some embodiments, the gate structure 110 further includes a hard mask (not shown) formed over the conductive layer 113. The hard mask may be formed by a deposition process or another suitable process. The hard mask may include silicon nitride, silicon oxynitride, silicon carbide, another suitable material, or a combination thereof. To simplify the diagram, one gate dielectric layer 111 and one conductive layer 113 are depicted herein for illustrating the gate structure 110.

In addition, in some embodiments, lightly doped regions (LDD) 120 are further formed in the semiconductor substrate 100. As shown in FIG. 1A, the lightly doped regions (LDD) 120 includes a first lightly doped region 121 and a second lightly doped region 122. The first lightly doped region 121 is adjacent to the first sidewall 110S1 of the gate structure 110. The second lightly doped region 122 is adjacent to the second sidewall 110S2 of the gate structure 110. In some embodiments, the lightly doped regions (LDD) 120 can be formed by using the gate structure as an implant mask.

Next, a gate spacer material layer 130 that includes one or more spacer material layers is formed over the semiconductor substrate 100, and the gate spacer material layer 130 covers the gate structure 110 (e.g. FIG. IB). Then, an initial gate spacer layer that has symmetrical portions respectively overlying the first sidewall and the second sidewall of the gate structure is formed (e.g. FIG. 1C). In this exemplified embodiment, four spacer material layers formed over the semiconductor substrate 100 are depicted for illustration. However, it should be noted that the number of the spacer material layer(s) for forming the initial gate spacer layer of the present disclosure is not limited to the exemplified embodiment provided herein.

Referring to FIG. 1B, a gate spacer material layer 130 having four spacer material layers is formed over the semiconductor substrate 100 and covers the gate structure 110. In some embodiments, the gate spacer material layer 130 includes a first spacer material layer 131, a second spacer material layer 132, a third spacer material layer 133 and a fourth spacer material layer 134. First, the first spacer material layer 131 is formed on the upper surface 100a of the semiconductor substrate 100 and conformally formed on the first sidewall 110S1 and the second sidewall 110S2 of the gate structure 110. In some embodiments, the first spacer material layer 131 also covers the isolation structure 108 and the lightly doped regions (LDD) 120 (e.g. including the first lightly doped region 121 and the second lightly doped region 122). As shown in FIG. 1B, the first sidewall 110S1 of the gate structure 110 includes the first sidewall 111S1 of the gate dielectric layer 111 and the first sidewall 113S1 of the conductive layer 113. The second sidewall 110S2 of the gate structure 110 includes the second sidewall 111S2 of the gate dielectric layer 111 and the second sidewall 113S2 of the conductive layer 113. Then, the second spacer material layer 132 is conformally formed on the first spacer material layer 131, the third spacer material layer 133 is conformally formed on the second spacer material layer 132 and the fourth spacer material layer 134 is conformally formed on the third spacer material layer 133.

Spacer materials can be selected and varied based on the design requirements for forming the semiconductor device. In some embodiments, the first spacer material layer 131 (as a liner spacer layer) is formed of silicon nitride, oxynitride, silicon oxide, or another suitable material. In some other embodiments, the first spacer material layer 131 is a silicon nitride layer with impurity of boron, carbon, fluorine, or combinations thereof. The precursor of a deposition process for forming the silicon nitride layer includes a silicon-containing gas, such as SiH₂Cl₂, Si₂H₆, SiH₄, Si₂Cl₆, or BTBAS, and a nitrogen-containing gas, such as NH₃, N₂, or N₂O. Also, the second spacer material layer 132, the third spacer material layer 133 and the fourth spacer material layer 134, for example, are dielectric layers with low dielectric constant (low-k). The k values of the second spacer material layer 132, the third spacer material layer 133 and the fourth spacer material layer 134 may be in a range from about 4.2 to about 5.5. In some embodiments, the first spacer material layer 131, the second spacer material layer 132, the third spacer material layer 133 and the fourth spacer material layer 134 are low-k dielectric with impurities therein. The precursor of the deposition process of the low-k dielectric with impurities may include a boron-containing gas, such as BCl₃, BH₃, or B₂H₆, or a carbon-containing gas, such as C₂H₄ or C₂H₆. In some embodiment, the space materials include oxide, nitride, oxynitride with boron, carbon, fluorine, or combinations thereof. In some embodiment, the space materials include silicon carbide with boron, nitrogen, fluorine, or combinations thereof. Also, it should be noted that suitable dielectric material of the fourth spacer material layer 134 will exhibit low K characteristics in conjunction with high etch selectivity in comparison to the underlying third spacer material layer 133.

In this exemplified embodiment, the first spacer material layer 131 and the third spacer material layer 133 include but not limited to silicon nitride, while the second spacer material layer 132 and the fourth spacer material layer 134 include but not limited to silicon oxide.

In addition, the first spacer material layer 131, the second spacer material layer 132, the third spacer material layer 133 and the fourth spacer material layer 134 may be formed by using commonly used techniques, such as plasma enhanced chemical vapor deposition (PECVD), low-pressure chemical vapor deposition (LPCVD), sub-atmospheric chemical vapor deposition (SACVD), atomic layer deposition (ALD), or another suitable deposition.

Referring to FIG. 1C, a gate spacer material layer 130 is patterned to form an initial gate spacer layer 140 having symmetrical portions 141 and 142 overlying the sidewalls of the gate structure 110. In this exemplified embodiment, each of the symmetrical portions 141 and 142 includes the patterned first spacer material layer 131', the patterned second spacer material layer 132', the patterned third spacer material layer 133' and the patterned fourth spacer material layer 134'. The patterning step may be performed by a wet etching process, a dry etching process, or combinations thereof. In some embodiments, the gate spacer material layer 130 is patterned by a dry etching process. In some embodiments, the gate spacer material layer 130 is patterned by an anisotropic dry etching process. Also, the gate spacer material layer 130 is patterned without any mask provided above the gate spacer material layer 130. Accordingly, as shown in FIG. 1C, the symmetrical portions 141 and 142 of the initial gate spacer layer 140 are formed on the first sidewall 110S1 and the second sidewall 110S2 of the gate structure 110, respectively. Also, the top surface 110a of the gate structure 110 (e.g. the top surface 113a of the conductive layer 113 in this exemplified embodiment) is exposed after the symmetrical portions 141 and 142 of the initial gate spacer layer 140 are formed.

Referring to FIG. 1D, FIG. 1E and FIG. 1F, which depict the steps of forming a gate spacer structure GS comprising two asymmetrical portions (e.g. the first spacer portion GS-1 and the second spacer portion GS-2) on the opposite sidewalls of the gate structure 110, in accordance with some embodiments. In this exemplary embodiment, the asymmetrical portions of the gate spacer structure GS on the opposite sidewalls of the gate structure 110 are introduced into the semiconductor device to extend the lateral distance (e.g. in the first direction D1, such as X-direction) between the gate structure and a drain region that is formed subsequently.

Referring to FIG. 1D, a patterned mask layer 150 is provided over the semiconductor substrate 100 to expose one of the symmetrical portions 141 and 142 of the initial gate spacer layer 140. In some embodiments, a source region and a drain region are subsequently formed adjacent to the first sidewall 110S1 and the second sidewall 110S2 of the gate structure 110, respectively. Therefore, the patterned mask layer 150 exposes the symmetrical portion 141 overlying the first sidewall 110S1 of the gate structure 110, but covers the symmetrical portion 142 overlying the second sidewall 110S2 of the gate structure 110. In some embodiments, the patterned mask layer 150 comprises material such as photoresists or the like.

Referring to FIG. 1E, a portion of the symmetrical portion 141 on the first sidewall 110S1 of the gate structure 110, that is not covered by the patterned mask layer 150, is removed. Accordingly, the size and the bottom surface of the symmetrical portion 141 can be reduced. The portion of the symmetrical portion 141 may be removed by etching process. The etching process may include a dry etching process, a wet etching process, another suitable process, or a combination thereof. In some embodiments, the portion of the symmetrical portion 141 is removed by selective etching processes. In this exemplified embodiment, the patterned third spacer material layer 133' and the patterned fourth spacer material layer 134' (FIG. 1B) of the symmetrical portion 141 are removed by selectively etching, thereby forming the remaining portions of the spacer material layers 131" and 132". The remaining portions of the spacer material layers 131" and 132" on the first sidewall 110S1 of the gate structure 110 can be collectively referred to as a smaller portion of the gate spacer structure GS. Also, the remaining portion 142 that is on the second sidewall 110S2 of the gate structure 110 and covered by the patterned mask layer 150 can be referred to as a larger portion of the gate spacer structure GS.

To briefly describe this exemplified embodiment, the remaining portions of the spacer material layers 131" and 132" on the first sidewall 110S1 of the gate structure 110 can be referred to as a first spacer portion GS-1 of the gate spacer structure GS. The remaining portion 142 that is on the second sidewall 110S2 of the gate structure 110 can be referred to as a second spacer portion GS-2 of the gate spacer structure GS.

After the asymmetrical portions of the gate spacer structure GS, for example, the first spacer portion GS-1 having a smaller bottom surface and the second spacer portion GS-2 having a larger bottom surface, is formed, the patterned mask layer 150 is removed. The patterned mask layer 150 may be removed by stripping, ashing, another suitable process, or a combination thereof.

Referring to FIG. 1F, heavily doped regions 160 such as a source region 161 and a drain region 162 are formed in the semiconductor substrate 100. The source region 161 and the drain region 162 are near the first sidewall 110S1 and the second sidewall 110S2 of the gate structure 110, respectively. According to the embodiments, the source region 161 and the drain region 162 are formed by using the gate structure 110 and the asymmetrical portions (i.e. the first spacer portion GS-1 and the second spacer portion GS-2) of the gate spacer structure GS as an implant mask. Therefore, no extra mask is required during formation of the source region 161 and the drain region 162, in accordance with some embodiments of the present disclosure.

Also, the inner edges of the source region 161 and the drain region 162 can be self-aligned with the outer edges of the first spacer portion GS-1 and the second spacer portion GS-2 of the gate spacer structure GS, in accordance with some embodiments of the present disclosure. As shown in FIG. 1F, the inner edge of the source region 161 is aligned with an outer edge OE1 of the first spacer portion GS-1, and the inner edge of the drain region 162 is aligned with an outer edge OE2 of the second spacer portion GS-2. In other words, no space material covers the top surface 161a of the source region 161 and the top surface 162a of the drain region 162, in accordance with some embodiments of the present disclosure. Therefore, according to some embodiments, the entire top surface 161a of the source region 161 and the entire top surface 162a of the drain region 162 provide large areas for forming silicide regions (not shown) on the source region 161 and the drain region 162 in the subsequent process.

In addition, according to some embodiments, the lateral distance (e.g. the second width W2) between the drain region 162 and the gate structure 110 is greater than the lateral distance (e.g. the first width W1) between the source region 161 and the gate structure 110, as shown in FIG. 1F. The lateral distance between the source region 161/the drain region 162 and the gate structure 110 may be defined in the first direction D1 (such as X-direction). In some embodiments, the first spacer portion GS-1 overlying the first sidewall 110S1 of the gate structure 110 has a first bottom surface B1, and the second spacer portion GS-2 overlying the second sidewall 110S2 of the gate structure 110 has a second bottom surface B2. The second bottom surface B2 is greater than the first bottom surface B1. In some embodiments, the first bottom surface B1 has a first width W1 (in the first direction D1) between the source region 161 and the gate structure 110, and the second bottom surface B2 has a second width W2 (in the first direction D1) between the drain region 162 and the gate structure 110, wherein the second width W2 is greater than the first width W1 (W2>W1), as shown in FIG. 1F. According to the embodiments, the extended distance between the drain region 162 and the gate structure 110 do increase the breakdown voltage and the zone of the safe operating area (SOA) of the semiconductor device.

In addition, in some embodiments, after the source region 161 and the drain region 162 are formed, the first lightly doped region 123 is positioned between the source region 161 and the gate structure 110, and the second lightly doped region 124 is positioned between the drain region 162 and the gate structure 110. As shown in FIG. 1F, the first lightly doped region 123 beneath the first spacer portion GS-1 is adjacent to the first sidewall 110S1 of the gate structure 110, and the second lightly doped region 124 beneath the second spacer portion GS-2 is adjacent to the second sidewall 110S2 (which is opposite the first sidewall 110S1) of the gate structure 110. Also, the first spacer portion GS-1 of the gate spacer structure GS is formed over the first lightly doped region 123, and the second spacer portion GS-2 of the gate spacer structure GS is formed over the second lightly doped region 124.

In addition, as shown in FIG. 1F, after the source region 161 and the drain region 162 are formed, the first lightly doped region 123 and the second lightly doped region 124 have different widths that extend along the upper surface 100a of the semiconductor substrate 100, in accordance with some embodiments of the present disclosure. In this exemplified embodiment, the width (in the first direction D1) of the second lightly doped region 124 between the gate structure 110 and the drain region 162 is greater than the width (in the first direction D1) of the first lightly doped region 123 between the gate structure 110 and the source region 161. As shown in FIG. 1F, the width of the second lightly doped region 124 between the gate structure 110 and the source region 161 can be referred to as the first width W1 of the first bottom surface B1 of the first spacer portion GS-1. Similarly, the width of the second lightly doped region 124 between the gate structure 110 and the drain region 162 can be referred to as the second width W2 of the second bottom surface B2 of the second spacer portion GS-2.

In addition, in some embodiments, the inner edge of the first lightly doped regions 123 and the inner edge of the second lightly doped region 124 in the semiconductor substrate 100 are aligned respectively with the inner edge IE1 of the first spacer portion GS-1 and the inner edge IE2 of the second spacer portion GS-2, as shown in FIG. 1F. Also, because the source region 161 and the drain region 162 are formed by using the gate structure 110 and the gate spacer structure GS as an implant mask, the outer edges of the first lightly doped region 123 and the second lightly doped region 124 that contact the source region 161 and the drain region 162 are aligned respectively with the outer edges of the two asymmetrical portions of the gate spacer structure GS after the source region 161 and the drain region 162 are formed. For example, the outer edge of the first lightly doped region 123 is aligned with the outer edge OE1 of the first spacer portion GS-1, and the outer edge of the second lightly doped region 124 is aligned with the outer edge OE2 of the second spacer portion GS-2.

Referring to FIG. 1G, in some embodiments, an inter-layer dielectric (ILD) layer 170 is formed over the semiconductor substrate 100. Then, the contact plugs are formed by filling contact openings (not shown) in the inter-layer dielectric layer 170 with conductive materials. As shown in FIG. 1G, the contact plugs 181, 182 and 183 contact the source region 161, the gate structure 110 and the drain region 162, respectively.

In some embodiments, before the inter-layer dielectric layer 170 is deposited, silicide regions (not shown) can be further formed on the source region 161, the gate structure 110 and the drain region 162 to reduce gate (e.g. polysilicon gate) contact resistance and source/drain contact resistance. In some embodiments, the silicide regions can be formed by blanket depositing a metal layer (not shown) on the previously formed structure shown in FIG. 1F, and an annealing process is performed. When annealed, the metal layer reacts with the underlying silicon and silicide regions are formed on the source region 161, the gate structure 110 and the drain region 162. The un-reacted metal layer is then removed after the annealing process.

In addition, in some embodiments, after the silicide regions are formed, a contact etch stop layer (not shown) is further formed by a blanket deposition to cover the entire structure in FIG. 1F. The contact etch stop layer can act as an etch stop layer during formation of contact openings, thereby protecting underlying regions from being over etched. Also, the contact etch stop layer provides a stress, preferably a tensile stress for an NMOS transistor, to the semiconductor device and enhances carrier mobility. Next, the inter-layer dielectric layer 170 is deposited on the contact etch stop layer. Then, the contact openings are made through the inter-layer dielectric layer 170 and those contact openings are filled with a conductive material layer. A planarization process, such as chemical mechanical planarization, another suitable planarization method or a combination thereof, is then performed to planarize the conductive material layer and the inter-layer dielectric material, thereby forming the contact plugs 181, 182 and 183 and the inter-layer dielectric layer 170 with planarized top surfaces, as shown in FIG. 1G. In some embodiments, the contact plugs 181, 182 and 183 contact the silicide regions (not shown) on the source region 161, the gate structure 110 and the drain region 162, respectively.

According to some embodiments, a semiconductor device includes a gate spacer structure GS having two asymmetrical portions (e.g. the first spacer portion GS-1 and the second spacer portion GS-2) respectively overlying opposite sidewalls (e.g. the first sidewall 110S1 and the second sidewall 110S2) of the gate structure 110. The inner edges of the source region 161 and the drain region 162 are aligned respectively with outer edges (e.g. OE1 and OE2) of the asymmetrical portions of the gate spacer structure GS. Also, the lateral distance (e.g. identical to the second width W2) between the drain region 162 and the gate structure 110 is greater than the lateral distance (e.g. identical to the first width W1) between the source region 161 and the gate structure 110. According to some embodiments, the extended distance (i.e. W2>W1) between the drain region 162 and the gate structure 110 do increase the breakdown voltage and the zone of the safe operating area (SOA) of the semiconductor device. Also, the extended distance between the drain region 162 and the gate structure 110 of the semiconductor device reduces the undesirable parasite capacitance between the gate structure 110 and a drain contact plug 183 that is connected to the drain region 162. In addition, more current is allowed to flow from the source to the drain terminal when the lateral distance (e.g. identical to the first width W1) between the source region 161 and the gate structure 110 is less than the lateral distance (e.g. identical to the second width W2) between the drain region 162 and the gate structure 110 of the semiconductor device. Thus, the electrical performances of the semiconductor device in accordance with some embodiments of the present disclosure can be greatly improved.

In addition, FIG. 1A-FIG. 1G provide a simple method for fabricating a semiconductor device in some embodiments by one-step deposition of the gate spacer material layer 130 (e.g. deposition of four spacer material layers 131, 132, 133 and 134), one-step etch of the gate spacer material layer 130 to form the initial gate spacer layer 140 having symmetrical portions 141 and 142, followed by removal of a portion of the symmetrical portion 141 near the subsequently formed source region 161. However, it should be noted that the present disclosure is not limited to the aforementioned method as shown in FIG. 1A-FIG. 1G. Other suitable methods are also applicable for forming the semiconductor device in some embodiments.

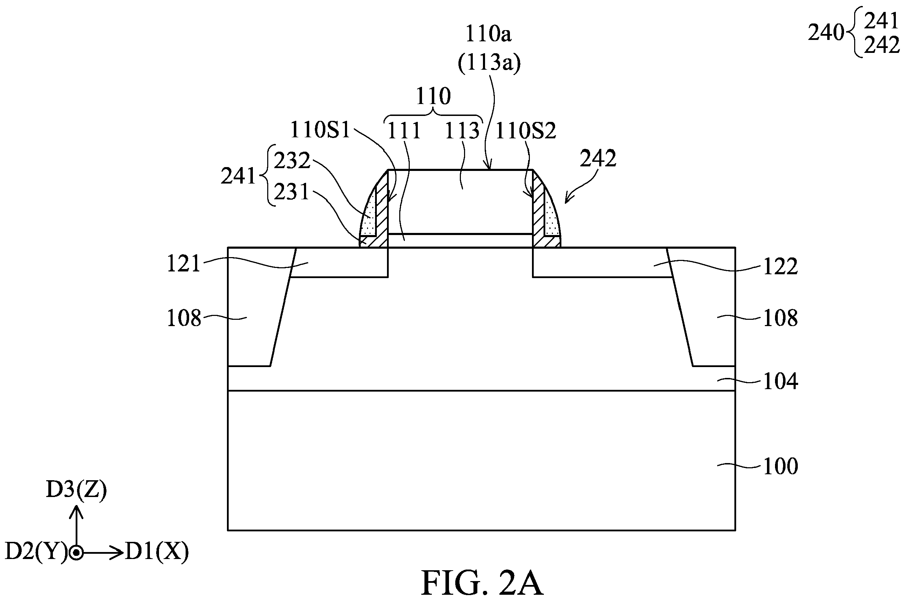

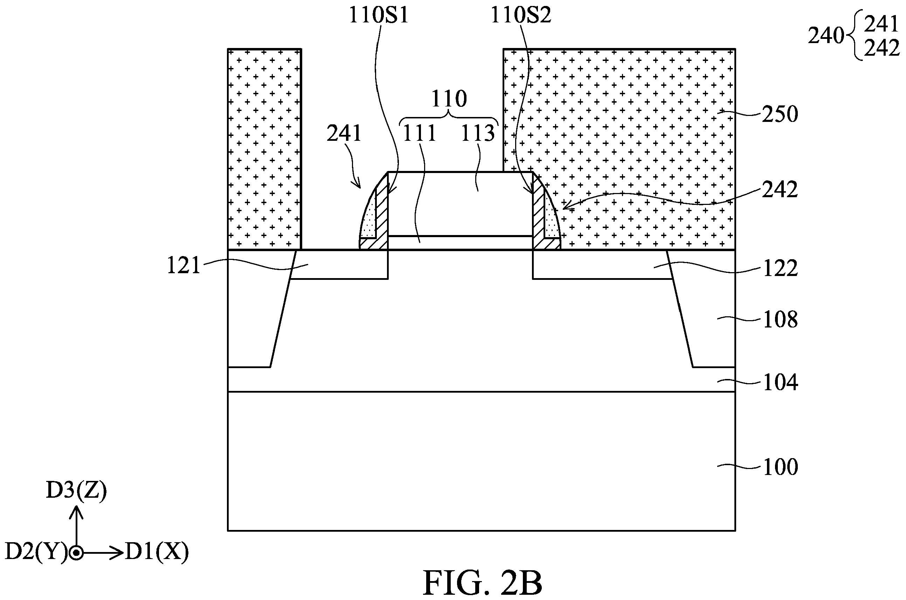

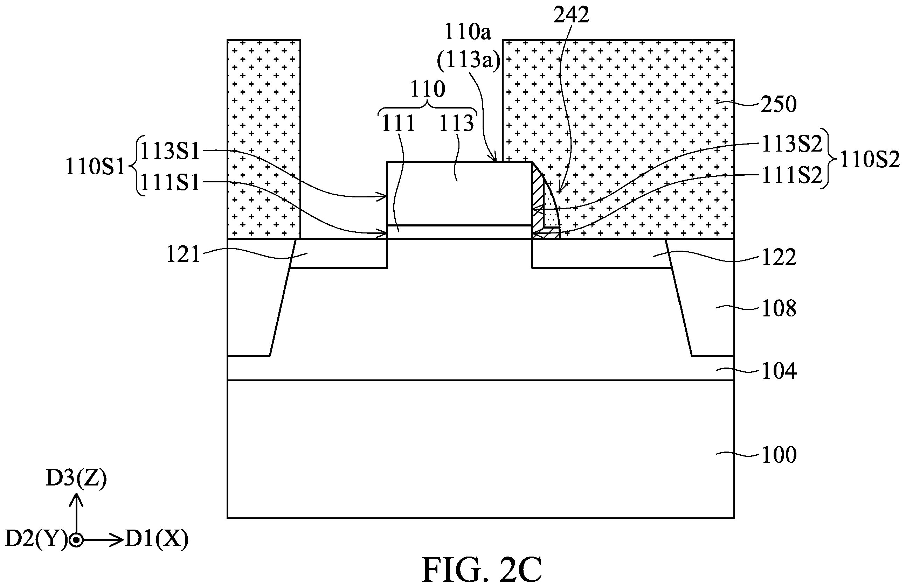

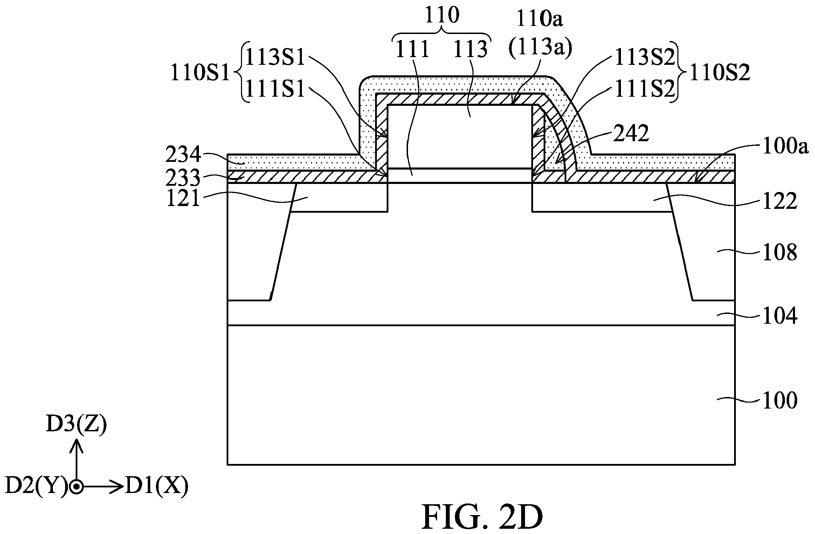

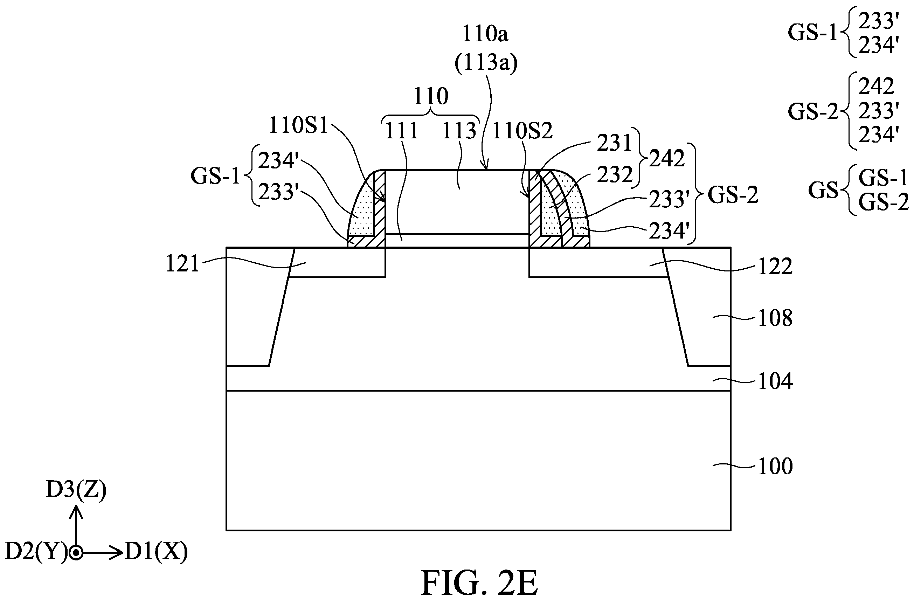

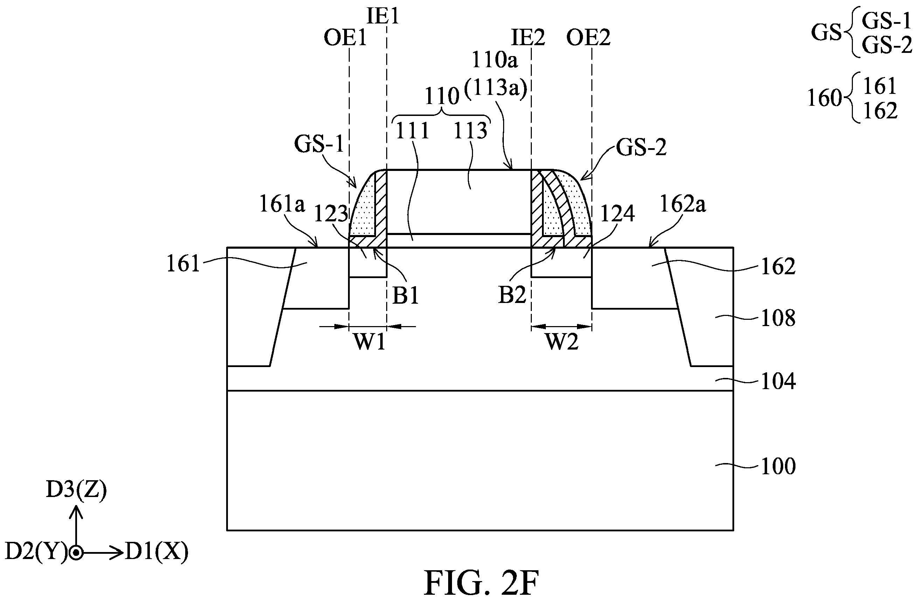

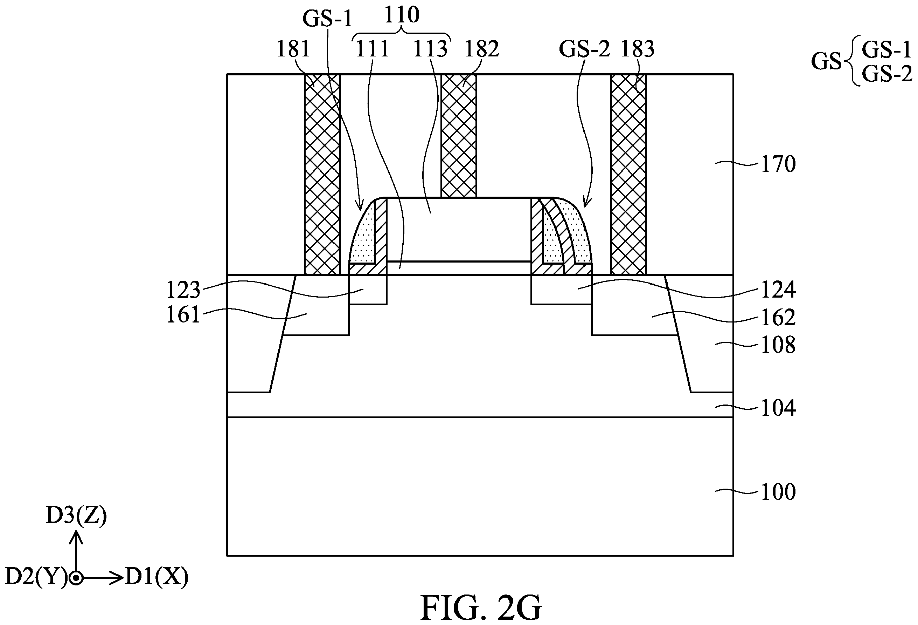

FIG. 2A, FIG. 2B, FIG. 2C, FIG. 2D, FIG. 2E, FIG. 2F and FIG. 2G are cross-sectional views of intermediate stages of a method of forming a semiconductor device, in accordance with some embodiments of the present disclosure. According to the method disclosed in this exemplified embodiment, two deposition steps are performed for making the gate spacer structure GS with two asymmetrical portions (e.g. the first spacer portion GS-1 and the second spacer portion GS-2) that are respectively on opposite sidewalls of the gate structure. Also, the same or similar reference numerals or reference designators denote the same or similar elements (such as components or layers) in FIG. 1A to FIG. 1G and FIG. 2A to FIG. 2G. For the purpose of brevity, the materials of the same or similar components/layers and processes of forming those components/layers are not repeated herein.

Referring to FIG. 2A, a structure having an initial gate spacer layer 240 with symmetrical portions 241 and 242 overlying the opposite sidewalls of the gate structure 110 is provided, in accordance with some embodiments of the present disclosure. Same or similar features in FIG. 2A and FIG. 1C are numbered the same or similar for the sake of simplicity and clarity.

In some embodiments, as shown in FIG. 2A, a semiconductor substrate 100 with a well region 104 and an isolation structure 108 adjacent to the well region 104 is provided. The semiconductor substrate 100 may be a silicon substrate. The isolation structure 108 extends downward from the upper surface of the semiconductor substrate 100 and is embedded in the semiconductor substrate 100. The isolation structure 108 may include shallow trench isolation (STI) elements. Also, a gate structure 110 is formed over the well region 104 of the semiconductor substrate 100. In some embodiments, the gate structure 110 includes a gate dielectric layer 111 and a conductive layer 113 on the gate dielectric layer 111.

The structures and materials of the semiconductor substrate 100, the well region 104, the isolation structure 108 and the gate structure 110 in FIG. 2A are the same as those in FIG. 1A for the previously described embodiment, so that the details of those features will not be redundantly repeated herein. In addition, the methods for forming the structures having the semiconductor substrate 100, the well region 104, the isolation structure 108 and the gate structure 110 in FIG. 2A have been provided in the previously described embodiment, and the process details will not be repeated herein.

In some embodiments, as shown in FIG. 2A, the lightly doped regions (LDD) 120 that includes a first lightly doped region 121 and a second lightly doped region 122 are further formed in the semiconductor substrate 100. The first lightly doped region 121 is adjacent to the first sidewall 110S1 of the gate structure 110. The second lightly doped region 122 is adjacent to the second sidewall 110S2 of the gate structure 110. In some embodiments, the lightly doped regions (LDD) 120 can be formed by using the gate structure 110 as an implant mask. The structure and material of the first lightly doped region 121 and the second lightly doped region 122 in FIG. 2A have been described in the aforementioned embodiment, so that the details of those elements will not be redundantly repeated herein. In addition, the methods for forming the first lightly doped region 121 and the second lightly doped region 122 in FIG. 2A are similar to those contents for the previously described embodiment, and the process details will not be repeated herein.

In some embodiments, as shown in FIG. 2A, the symmetrical portions 241 and 242 of the initial gate spacer layer 240 are formed overlying the first sidewall 110S1 and the second sidewall 110S2 of the gate structure 110, respectively. In some embodiments, the initial gate spacer layer 240 can be formed by conformally depositing two spacer material layers over the semiconductor substrate 100 and covering the gate structure 110, and then the spacer material layers are patterned to form the symmetrical portions 241 and 242 of the initial gate spacer layer 240. The patterning step may be performed by a wet etching process, a dry etching process, or combinations thereof. In some embodiments, the spacer material layers are patterned by a dry etching process. In some embodiments, the spacer material layers are patterned by an anisotropic dry etching process. In this exemplified embodiment, each of the symmetrical portions 241 and 242 includes a patterned first spacer material layer 231 and a patterned second spacer material layer 232. In one example, the patterned first spacer material layer 231 includes but not limited to silicon nitride, while the patterned second spacer material layer 232 includes but not limited to silicon oxide. Suitable material of the patterned first spacer material layer 231 and the patterned second spacer material layer 232 in FIG. 2A are similar to those contents for the previously described embodiment, and the details will not be repeated herein. In addition, the top surface 110a of the gate structure 110 (e.g. the top surface 113a of the conductive layer 113 in this exemplified embodiment) is exposed after the symmetrical portions 241 and 242 of the initial gate spacer layer 240 are formed.

Referring to FIG. 2B, in some embodiments, a patterned mask layer 250 is provided over the semiconductor substrate 100. The patterned mask layer 250 exposes one of the symmetrical portions 241 and 242 of the initial gate spacer layer 240. In some embodiments, a source region and a drain region will be subsequently formed adjacent to the first sidewall 110S1 and the second sidewall 110S2 of the gate structure 110, respectively. Thus, the patterned mask layer 250 exposes the symmetrical portion 241 overlying the first sidewall 110S1 of the gate structure 110, and covers the symmetrical portion 242 overlying the second sidewall 110S2 of the gate structure 110. In some embodiments, the patterned mask layer 250 comprises material such as photoresists or the like.

Referring to FIG. 2C, in some embodiments, the symmetrical portion 241 on the first sidewall 110S1 of the gate structure 110 and not covered by the patterned mask layer 250 is removed. The symmetrical portion 241 can be partially removed or completely removed, as long as the bottom width (in the first direction D1) of the remaining portion of the symmetrical portion 241 overlying the first sidewall 110S1 of the gate structure 110 is less than the bottom width (in the first direction D1) of the symmetrical portion 242 overlying the second sidewall 110S2 of the gate structure 110. In this exemplified embodiment, the symmetrical portion 241 is completely removed, and the first sidewall 110S1 of the gate structure 110 is exposed.

In some embodiments, the symmetrical portion 241 is removed by selective etching process. The etching process may include a dry etching process, a wet etching process, another suitable process, or a combination thereof. After the symmetrical portion 241 of the initial gate spacer layer 240 is removed, the patterned mask layer 250 is removed. The patterned mask layer 250 may be removed by stripping, ashing, another suitable process, or a combination thereof.

Also, since the patterned mask layer 250 fully covers the symmetrical portion 242 of the initial gate spacer layer 240, the symmetrical portion 242 completely remains on the second sidewall 110S2 of the gate structure 110 after the patterned mask layer 250 is removed. For the purpose of brevity, the symmetrical portion 242 remained on the second sidewall 110S2 of the gate structure 110 can be referred to as a remaining initial spacer portion 242 in the following descriptions.

Next, in some embodiments, one or more spacer material layers are formed on the exposed first sidewall 110S1 of the gate structure 110 and overlying the remaining initial spacer portion 242 on the second sidewall 110S2 of the gate structure 110.

Referring to FIG. 2D, in some embodiments, a third spacer material layer 233 is conformally formed on the gate structure 110 and the remaining initial spacer portion 242. Specifically, the third spacer material layer 233 is conformally formed on the upper surface 100a of the semiconductor substrate 100, the first sidewall 110S1 and the top surface 110a of the gate structure 110, and the surface of the remaining initial spacer portion 242. Then, in some embodiments, a fourth spacer material layer 234 is conformally formed on the third spacer material layer 233.

The third spacer material layer 233 and the fourth spacer material layer 234 may include different materials, in accordance with some embodiments. In one example, the third spacer material layer 233 includes but not limited to silicon nitride, while the fourth spacer material layer 234 includes but not limited to silicon oxide. Suitable materials of the third spacer material layer 233 and the fourth spacer material layer 234 in FIG. 2D have been provided in the previously described embodiment, and the details will not be repeated herein.

Next, in some embodiments, the spacer material layers that are formed over the upper surface 100a of the semiconductor substrate 100 and cover the gate structure 110 are patterned to form a gate spacer structure GS. As shown in FIG. 2D, the gate spacer structure GS has two asymmetrical portions, such as the first spacer portion GS-1 and the second spacer portion GS-2, on the opposite sidewalls of the gate structure 110, in accordance with some embodiments.

Referring to FIG. 2E, in some embodiments, a patterning step is performed on the spacer material layers that include the remaining initial spacer portion 242 on the second sidewall 110S2 of the gate structure 110 and a blanket deposition of the third spacer material layer 233 and the fourth spacer material layer 234 to form a gate spacer structure GS. The gate spacer structure GS includes two asymmetrical portions (i.e. the first spacer portion GS-1 and the second spacer portion GS-2) on the opposite sidewalls of the gate structure 110. It should be noted that those spacer material layers can be patterned to form the gate spacer structure GS without providing any mask above.

In some embodiments, the patterned third spacer material layer 233' and the patterned fourth spacer material layer 234' on the first sidewall 110S1 of the gate structure 110 collectively form the first spacer portion GS-1 of the gate spacer structure GS. In some embodiments, the remaining initial spacer portion 242, the patterned third spacer material layer 233' and the patterned fourth spacer material layer 234' on the second sidewall 110S2 of the gate structure 110 collectively form the second spacer portion GS-2 of the gate spacer structure GS.

It should be noted that same or similar features of the structures in FIG. 2E and FIG. 1E are numbered the same or similar for the sake of simplicity and clarity. The configurations of those same or similar features in FIG. 2E and FIG. 1E are similar to those contents for the previously described embodiment, and the details will not be repeated herein. Also, the methods for forming the structures having the gate spacer structure GS having two asymmetrical portions on the opposite sidewalls of the gate structure 110 in FIG. 2E have been provided in the previously described embodiment, and the process details will not be repeated herein.

Referring to FIG. 2F, the heavily doped regions 160 that includes a source region 161 and a drain region 162 are formed in the semiconductor substrate 100. The source region 161 and the drain region 162 are formed near the first sidewall 110S1 and the second sidewall 110S2 of the gate structure 110, respectively. According to the embodiments, the source region 161 and the drain region 162 are formed by using the gate structure 110, the first spacer portion GS-1 and the second spacer portion GS-2 of the gate spacer structure GS as an implant mask. Therefore, no extra mask is required for forming the source region 161 and the drain region 162, in accordance with some embodiments of the present disclosure.

In this exemplified embodiment, the source region 161 and the drain region 162 can be self-aligned with the outer edges of the first spacer portion GS-1 and the second spacer portion GS-2 of the gate spacer structure GS. As shown in FIG. 2F, the inner edge of the source region 161 is aligned with the outer edge OE1 of the first spacer portion GS-1, and the inner edge of the drain region 162 is aligned with the outer edge OE2 of the second spacer portion GS-2. Also, no space material covers the top surface 161a of the source region 161 and the top surface 162a of the drain region 162, in accordance with some embodiments of the present disclosure. According to some embodiments, the entire top surface 161a of the source region 161 and the entire top surface 162a of the drain region 162 provide large areas for forming silicide regions (not shown) on the source region 161 and the drain region 162 in the subsequent process.

In addition, according to some embodiments, the lateral distance (e.g. the second width W2) between the drain region 162 and the gate structure 110 is greater than the lateral distance (e.g. the first width W1) between the source region 161 and the gate structure 110, as shown in FIG. 2F. The lateral distance between the source region 161/the drain region 162 and the gate structure 110 can be defined in the first direction D1 (such as X-direction). In some embodiments, the first spacer portion GS-1 overlying the first sidewall 110S1 of the gate structure 110 has a first bottom surface B1, and the second spacer portion GS-2 overlying the second sidewall 110S2 of the gate structure 110 has a second bottom surface B2. The second bottom surface B2 is greater than the first bottom surface B1. In some embodiments, the first bottom surface B1 has a first width W1 (e.g. in the first direction D1) between the source region 161 and the gate structure 110, and the second bottom surface B2 has a second width W2 (e.g. in the first direction D1) between the drain region 162 and the gate structure 110. The second width W2 is greater than the first width W1 (W2>W1), as shown in FIG. 2F. According to the embodiments, the extended distance between the drain region 162 and the gate structure 110 increases the breakdown voltage and the zone of the safe operating area (SOA) of the semiconductor device.

In addition, in some embodiments, after the source region 161 and the drain region 162 are formed, the first lightly doped region 123 is positioned between the source region 161 and the gate structure 110, and the second lightly doped region 124 is positioned between the drain region 162 and the gate structure 110. As shown in FIG. 2F, the first lightly doped region 123 is adjacent to the first sidewall 110S1 of the gate structure 110, and the second lightly doped region 124 is adjacent to the second sidewall 110S2 of the gate structure 110. Also, the first spacer portion GS-1 of the gate spacer structure GS is formed over the first lightly doped region 123, and the second spacer portion GS-2 of the gate spacer structure GS is formed over the second lightly doped region 124. After the source region 161 and the drain region 162 are formed, the first lightly doped region 123 and the second lightly doped region 124 have different widths that extend along the upper surface 100a of the semiconductor substrate 100, in accordance with some embodiments of the present disclosure. In this exemplified embodiment, the width (in the first direction D1) of the second lightly doped region 124 between the gate structure 110 and the drain region 162 is greater than the width (in the first direction D1) of the first lightly doped region 123 between the gate structure 110 and the source region 161. As shown in FIG. 2F, the width of the second lightly doped region 124 between the gate structure 110 and the source region 161 can be referred to as the first width W1 of the first bottom surface B1 of the first spacer portion GS-1. Similarly, the width of the second lightly doped region 124 between the gate structure 110 and the drain region 162 can be referred to as the second width W2 of the second bottom surface B2 of the second spacer portion GS-2.

In addition, in some embodiments, the inner edges of the first lightly doped regions 123 and the second lightly doped region 124 in the semiconductor substrate 100 are aligned respectively with the inner edge IE1 of the first spacer portion GS-1 and the inner edge IE2 of the second spacer portion GS-2, as shown in FIG. 2F. Also, because the source region 161 and the drain region 162 are formed by using the gate structure 110 and the gate spacer structure GS as an implant mask, the outer edges of the first lightly doped region 123 and the second lightly doped region 124 that respectively contact the source region 161 and the drain region 162 are aligned with the outer edges of the two asymmetrical portions of the gate spacer structure GS after implantation of the source region 161 and the drain region 162 is performed. For example, the outer edge of the first lightly doped region 123 is aligned with the outer edge OE1 of the first spacer portion GS-1, and the outer edge of the second lightly doped region 124 is aligned with the outer edge OE2 of the second spacer portion GS-2.

Referring to FIG. 2G, in some embodiments, an inter-layer dielectric (ILD) layer 170 is formed over the semiconductor substrate 100. Then, the contact plugs are formed by filling the contact openings in the inter-layer dielectric (ILD) layer 170 with conductive materials. As shown in FIG. 2G, the contact plugs 181, 182 and 183 contact the source region 161, the gate structure 110 and the drain region 162, respectively.

It should be noted that same or similar features of the structures in FIG. 2G and FIG. 1G are numbered the same or similar for the sake of simplicity and clarity. The configurations of those same or similar features in FIG. 2G and FIG. 1G have been provided in the previously described embodiment, and the details will not be repeated herein. Also, the methods for forming the structure that has an inter-layer dielectric (ILD) layer 170 covering the gate spacer structure GS (including two asymmetrical portions GS-1 and GS-2 on the opposite sidewalls of the gate structure 110) and the contact plugs 181, 182 and 183 in FIG. 2G have been described in the previously described embodiment, and the process details will not be repeated herein.

In addition, in some embodiments, before the inter-layer dielectric (ILD) layer 170 is deposited, silicide regions (not shown) can be formed on the source region 161, the gate structure 110 and the drain region 162 to reduce gate (e.g. polysilicon gate) contact resistance and source/drain contact resistance. Formation of the silicide regions has been described in the previously described embodiment, and the process details thus will not be repeated herein.

In addition, in some embodiments, after the silicide regions are formed, a contact etch stop layer (not shown) is further formed by a blanket deposition to cover the entire structure as shown in FIG. 2F. The contact etch stop layer can act as an etch stop layer during the formation of contact openings to protect underlying regions from being over etched. The inter-layer dielectric layer 170 is deposited on the contact etch stop layer, and the contact plugs 181, 182 and 183 are made through the inter-layer dielectric (ILD) layer 170 by forming contact openings (not shown) and filling those openings with a conductive material layer. In some embodiments, the contact plugs 181, 182 and 183 contact the silicide regions on the source region 161, the gate structure 110 and the drain region 162, respectively.

Also, the configurations of the gate spacer structures GS in the aforementioned embodiments, such as the shapes and arrangements of the spacer material layers in the first spacer portion GS-1 and the second spacer portion GS-2 in FIG. 1F and FIG. 2F, are merely provided for illustration of some applicable types. The present disclosure is not limited to the structural configurations of the gate spacer structures GS in the previously described embodiments. According to the present disclosure, the first spacer portion GS-1 and the second spacer portion GS-2 of the gate spacer structures GS may have varied shapes and arrangements of the spacer material layers to achieve the spacer portion(i.e. GS-2) near the drain region having the greater bottom width than the spacer portion (i.e. GS-1) near the source region.

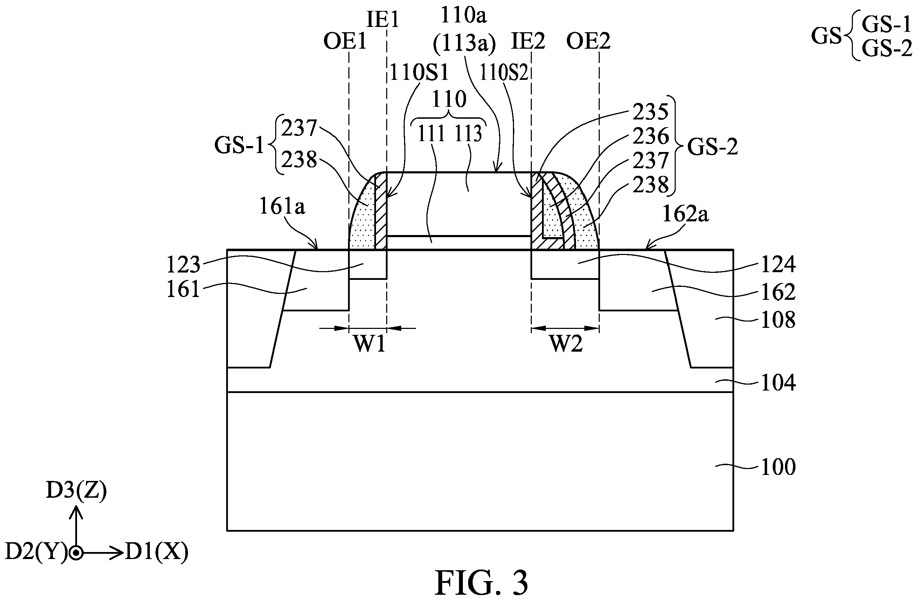

FIG. 3 is a cross-sectional view of an intermediate stage of a semiconductor device, in accordance with some embodiments of the present disclosure. The intermediate structure in FIG. 3 is identical to the intermediate structures in FIG. 1F and FIG. 2F except for the configuration of the gate spacer structure GS. Same or similar features of the structures in FIG. 1F, FIG. 2F and FIG. 3 are numbered the same or similar for the sake of simplicity and clarity.

The configurations of those same or similar features in FIG. 1F, FIG. 2F and FIG. 3 have been described in the previously described embodiments, and the details will not be repeated herein. Also, the method for forming the structure in FIG. 3 that has a well region 104 and the isolation structure 108 in the semiconductor substrate 100, the gate structure 110, the gate spacer structure GS having two asymmetrical portions (e.g. the first spacer portion GS-1 and the second spacer portion GS-2) on the opposite sidewalls of the gate structure 110, the first lightly doped region 123, the second lightly doped region 124, the source region 161 and the drain region 162 are similar to those contents in the previously described embodiment, and the process details will not be repeated herein.

Referring to FIG. 3, in some embodiments, a patterned first spacer material layer 235, a patterned second spacer material layer 236, a patterned third spacer material layer 237 and a patterned fourth spacer material layer 238 on the second sidewall 110S2 of the gate structure 110 collectively form a second spacer portion GS-2 of the gate spacer structure GS. In some embodiments, the patterned third spacer material layer 237 and the patterned fourth spacer material layer 238 on the first sidewall 110S1 of the gate structure 110 collectively form a first spacer portion GS-1 of the gate spacer structure GS.

In one example, the patterned first spacer material layer 235 and the patterned third spacer material layer 237 include but not limited to silicon nitride, while the patterned second spacer material layer 236 and the patterned fourth spacer material layer 238 include but not limited to silicon oxide. Suitable materials of the patterned first spacer material layer 235, the patterned second spacer material layer 236, the patterned third spacer material layer 237 and the patterned fourth spacer material layer 238 in FIG. 3 have been provided in the previously described embodiment, and the details will not be repeated herein.

Variable methods can be applied for forming the gate spacer structure GS in FIG. 3. One of the methods for fabricating the gate spacer structure GS in FIG. 3 is described below for exemplification. First, a remaining spacer portion that includes the patterned first spacer material layer 235 and the patterned second spacer material layer 236 is formed on the second sidewall 110S2 of the gate structure 110, while the first sidewall 110S1 of the gate structure 110 is exposed. Then, a third spacer material layer (not shown) is conformally formed on the upper surface 100a of the semiconductor substrate 100, the first sidewall 110S1 and the top surface 110a of the gate structure 110, and the surface of the remaining spacer portion (including the patterned first spacer material layer 235 and the patterned second spacer material layer 236) on the second sidewall 110S2 of the gate structure 110. Next, a patterning step is performed on those spacer material layers to form the patterned third spacer material layers 237 on the first sidewall 110S1 of the gate structure 110 and on the patterned second spacer material layer 236 adjacent to the second sidewall 110S2 of the gate structure 110. Next, a fourth spacer material layer (not shown) is conformally formed on the upper surface 100a of the semiconductor substrate 100, the patterned third spacer material layers 237 and the exposed top surface 110a of the gate structure 110, followed by a patterning step performed on the fourth spacer material layer to form the patterned fourth spacer material layers 238 on the patterned third spacer material layers 237. It should be noted that no extra mask is required to perform those patterning steps. In addition, the top surface 110a of the gate structure 110 (e.g. the top surface 113a of the conductive layer 113 in this exemplified embodiment) is exposed after the asymmetrical portions (i.e. the first spacer portion GS-1 and the second spacer portion GS-2) of the gate spacer structure GS are formed.

In addition, according to some embodiments, the lateral distance (e.g. the second width W2) between the drain region 162 and the gate structure 110 is greater than a lateral distance (e.g. the first width W1) between the source region 161 and the gate structure 110, as shown in FIG. 3. In some embodiments, the first spacer portion GS-1 overlying the first sidewall 110S1 of the gate structure 110 has a first bottom surface, and the second spacer portion GS-2 overlying the second sidewall 110S2 of the gate structure 110 has a second bottom surface. In some embodiments, the first bottom surface has a first width W1 (e.g. in the first direction D1) between the source region 161 and the gate structure 110, and the second bottom surface has a second width W2 (e.g. in the first direction D1) between the drain region 162 and the gate structure 110. The second width W2 is greater than the first width W1 (W2>W1), as shown in FIG. 3.

Although the configuration of the gate spacer structure GS in FIG. 3 is different from the configurations of the gate spacer structures GS in FIG. 1F and FIG. 2F, the extended distance between the drain region 162 and the gate structure 110 in FIG. 3, in accordance with some embodiments, do increase the breakdown voltage and the zone of the safe operating area (SOA) of the semiconductor device.

According to the embodiments described above, the gate spacer structure GS of the semiconductor device is formed of several spacer material layers, wherein the two asymmetrical portions (i.e. GS-1 and GS-2) of the gate spacer structure GS respectively overlying the first sidewall and the second sidewall of the gate structure each has a different number of spacer material layers. However, the present disclosure is not limited the aforementioned configurations of the gate spacer structures GS. It should be noted that those multilayer spacers of the first spacer portion GS-1 and the second spacer portion GS-2 in the previously described embodiments are merely for providing some examples of the gate spacer structures GS.

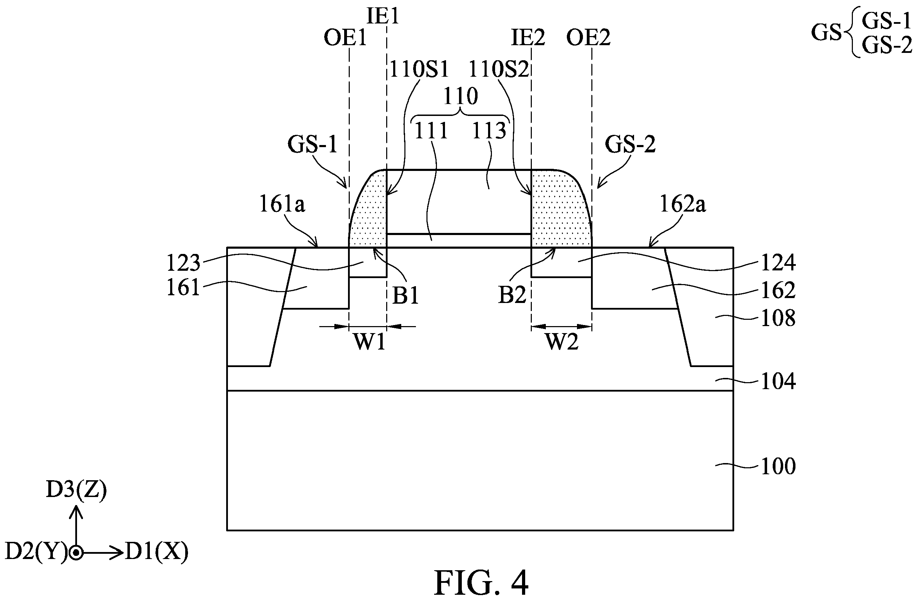

FIG. 4 is a cross-sectional view of an intermediate stage of a semiconductor device, in accordance with some embodiments of the present disclosure. The intermediate structure in FIG. 4 is identical to the intermediate structures in FIG. 1F, FIG. 2F and FIG. 3 except for the configuration of the gate spacer structure GS. Same or similar features of the structures in FIG. 1F, FIG. 2F, FIG. 3 and FIG. 4 are numbered the same or similar for the sake of simplicity and clarity.

The configurations of those same or similar features in FIG. 1F, FIG. 2F, FIG. 3 and FIG. 4 are similar to those contents for the previously described embodiment, and the details will not be repeated herein. Also, the method for forming the structure in FIG. 4 that has a well region 104 and the isolation structure 108 in the semiconductor substrate 100, the gate structure 110, the gate spacer structure GS having two asymmetrical portions (e.g. the first spacer portion GS-1 and the second spacer portion GS-2) on the opposite sidewalls of the gate structure 110, the first lightly doped region 123, the second lightly doped region 124, the source region 161 and the drain region 162 have been provided in the previously described embodiment, and the process details thus will not be repeated herein.

Referring to FIG. 4, in some embodiments, the gate spacer structure GS is made of a single spacer material layer. That is, each of the first spacer portion GS-1 and the second spacer portion GS-2 of the gate spacer structure GS includes one spacer material layer. The spacer material layer of the first spacer portion GS-1 and the second spacer portion GS-2 may include silicon nitride, silicon oxide, or another suitable material.

In some embodiments, the first spacer portion GS-1 and the second spacer portion GS-2 of the gate spacer structure GS respectively overlying the first sidewall 110S1 and the second sidewall 110S2 of the gate structure 110 have different bottom widths of the spacer material layer. As shown in FIG. 4, the lateral distance (e.g. the second width W2) between the drain region 162 and the gate structure 110 is greater than the lateral distance (e.g. the first width W1) between the source region 161 and the gate structure 110. In some embodiments, the first spacer portion GS-1 overlying the first sidewall 110S1 of the gate structure 110 has a first bottom surface, and the second spacer portion GS-2 overlying the second sidewall 110S2 of the gate structure 110 has a second bottom surface. In some embodiments, the first bottom surface has a first width W1 (e.g. the bottom width in the first direction D1) between the source region 161 and the gate structure 110, and the second bottom surface has a second width W2 (e.g. the bottom width in the first direction D1) between the drain region 162 and the gate structure 110. The second width W2 is greater than the first width W1 (W2>W1), as shown in FIG. 4.

Although the configuration of the gate spacer structure GS in FIG. 4 is different from the configurations of the gate spacer structures GS in FIG. 1F, FIG. 2F and FIG. 3, the extended distance between the drain region 162 and the gate structure 110 in FIG. 4 increases the breakdown voltage and the zone of the safe operating area (SOA) of the semiconductor device.

According to some embodiments described above, the semiconductor devices and methods of forming the same achieve several advantages. In some embodiments, the gate spacer structure GS has two asymmetrical portions (e.g. the first spacer portion GS-1 and the second spacer portion GS-2) respectively overlying the opposite sidewalls (e.g. the first sidewall 110S1 and the second sidewall 110S2) of the gate structure 110 in a semiconductor device. The lateral distance (e.g. referred to as the second width W2) between the drain region 162 and the gate structure 110 is greater than the lateral distance (e.g. referred to as the first width W1) between the source region 161 and the gate structure 110 (W2>W1). The extended distance between the drain region 162 and the gate structure 110 increase the breakdown voltage and the zone of the safe operating area (SOA) of the semiconductor device. Also, the extended distance between the drain region 162 and the gate structure 110 of the semiconductor device reduces the undesirable parasite capacitance between the gate structure 110 and a drain contact plug 183 that is connected to the drain region 162. In addition, more current is allowed to flow from the source to the drain terminal when the lateral distance (e.g. referred to as the first width W1) between the source region 161 and the gate structure 110 is less than the lateral distance (e.g. referred to as the second width W2) between the drain region 162 and the gate structure 110 of the semiconductor device. Also, the method of forming the semiconductor device, in accordance with some embodiments, is simple and compatible with the current processes. The structural configurations of the features in the semiconductor device formed by the method in accordance with some embodiments also bring some advantages. For example, the source region 161 and the drain region 162 formed in the semiconductor substrate are self-aligned with outer edges (e.g. OE1 and OE2) of the asymmetrical portions of the gate spacer structure GS, thereby providing large contact areas for the contact plugs disposed on the source region 161 and the drain region 162 in the subsequent process. According to the aforementioned descriptions, the electrical performances of the semiconductor device, in accordance with some embodiments of the present disclosure, can be significantly improved.

In one exemplary aspect, the present disclosure is directed to a semiconductor device. The semiconductor device includes a semiconductor substrate having a well region and a gate structure formed over the well region of the semiconductor substrate. In some embodiments, the gate structure has a first sidewall and a second sidewall. The second sidewall is opposite the first sidewall. The semiconductor device also includes a gate spacer structure having two asymmetrical portions. In some embodiments, the asymmetrical portions of the gate spacer structure are formed on the first sidewall and the second sidewall of the gate structure, respectively. The semiconductor device also includes a source region and a drain region in the semiconductor substrate, and the inner edges of the source region and the drain region are aligned respectively with the outer edges of the asymmetrical portions of the gate spacer structure. Also, the lateral distance between the drain region and the gate structure is greater than the lateral distance between the source region and the gate structure.

In some embodiments, one asymmetrical portion that is formed adjacent to the drain region has a greater bottom surface than the other asymmetrical portion that is adjacent to the source region. In some embodiments, the source region and the drain region are respectively positioned near the first sidewall and the second sidewall of the gate structure. In some embodiments, the gate spacer structure is made of a single spacer material layer, and the spacer material layer of the two asymmetrical portions of the gate spacer structure respectively overlying the first sidewall and the second sidewall of the gate structure have different bottom widths. In some embodiments, the gate spacer structure is made of multiple spacer material layers, and the two asymmetrical portions of the gate spacer structure respectively overlying the first sidewall and the second sidewall of the gate structure each has a different number of spacer material layers. In some embodiments, the semiconductor device further includes lightly doped regions in the semiconductor substrate and beneath the two asymmetrical portions of the gate spacer structure, wherein the lightly doped regions have different widths that extend along the upper surface of the semiconductor substrate. In some embodiments, the outer edges of the lightly doped regions are aligned with the outer edges of the two asymmetrical portions of the gate spacer structure. In some embodiments, the gate spacer structure includes a first spacer portion overlying the first sidewall of the gate structure and a second spacer portion overlying the second sidewall of the gate structure, wherein the bottom surface of the first spacer portion has a first width between the source region and the gate structure, and the bottom surface of the second spacer portion has a second width between the drain region and the gate structure, and the second width is greater than the first width.

In another exemplary aspect, the present disclosure is directed to a method of forming a semiconductor device. The method includes providing a semiconductor substrate having a well region and an isolation structure adjacent to the well region. A gate structure is formed over the well region of the semiconductor substrate. The gate structure has a first sidewall and a second sidewall. The second sidewall is opposite the first sidewall. A gate spacer structure is formed that comprises two asymmetrical portions that overlie the first sidewall and the second sidewall of the gate structure. A source region and a drain region are formed in the semiconductor substrate. The source region and the drain region are aligned with the outer edges of the asymmetrical portions of the gate spacer structure. Also, the lateral distance between the drain region and the gate structure is greater than the lateral distance between the source region and the gate structure.

In some embodiments, forming the gate spacer structure includes forming an initial gate spacer layer having symmetrical portions respectively overlying the first sidewall and the second sidewall of the gate structure; partially removing one of the symmetrical portions that is on the first sidewall of the gate structure, wherein the other symmetrical portion remains on the second sidewall of the gate structure. In some other embodiments, forming the gate spacer structure includes forming an initial gate spacer layer having symmetrical portions that overlie the first sidewall and the second sidewall of the gate structure; removing the symmetrical portion that is on the first sidewall of the gate structure to expose the first sidewall of the gate structure, while the other symmetrical portion remains on the second sidewall of the gate structure and can be referred to as a remaining initial spacer portion; forming a spacer material overlying the exposed first sidewall of the gate structure and overlying the remaining initial spacer portion on the second sidewall of the gate structure.

It should be noted that the details of the structures and fabrications of the embodiments are provided for exemplification, and the described details of the embodiments are not intended to limit the present disclosure. It should be noted that not all embodiments of the invention are shown. Modifications and variations can be made without departing from the spirit of the disclosure to meet the requirements of the practical applications. Thus, there may be other embodiments of the present disclosure which are not specifically illustrated. Furthermore, the accompanying drawings are simplified for clear illustrations of the embodiment. Sizes and proportions in the drawings may not be directly proportional to actual products. Thus, the specification and the drawings are to be regard as an illustrative sense rather than a restrictive sense.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor device, comprising:
a semiconductor substrate having a well region;
a gate structure formed over the well region of the semiconductor substrate, wherein the gate structure has a first sidewall and a second sidewall opposite the first sidewall;
a gate spacer structure comprising two asymmetrical portions overlying the first sidewall and the second sidewall of the gate structure; and
a source region and a drain region formed in the semiconductor substrate, wherein the source region and the drain region are aligned with outer edges of the asymmetrical portions of the gate spacer structure,
wherein a lateral distance between the drain region and the gate structure is greater than a lateral distance between the source region and the gate structure.

2. The semiconductor device as claimed in claim 1, wherein bottom surfaces of the two asymmetrical portions of the gate spacer structure are formed over the well region, and the bottom surface of one of the two asymmetrical portions that is adjacent to the drain region is greater than the bottom surface of the other asymmetrical portion that is adjacent to the source region.

3. The semiconductor device as claimed in claim 1, wherein the source region and the drain region are respectively positioned near the first sidewall and the second sidewall of the gate structure,
wherein the gate spacer structure preferably comprises:
a smaller spacer portion between the source region and the first sidewall of the gate structure; and
a larger spacer portion between the drain region and the second sidewall of the gate structure.

4. The semiconductor device as claimed in one of the preceding claims, wherein the gate spacer structure is made of a single spacer material layer, and the spacer material layer of the two asymmetrical portions of the gate spacer structure respectively overlying the first sidewall and the second sidewall of the gate structure have different bottom widths.

5. The semiconductor device as claimed in one of the preceding claims, wherein the gate spacer structure is made of multiple spacer material layers, and the two asymmetrical portions of the gate spacer structure respectively overlying the first sidewall and the second sidewall of the gate structure each has a different number of spacer material layers.

6. The semiconductor device as claimed in one of the preceding claims, further comprising:
lightly doped regions formed in the semiconductor substrate and beneath the two asymmetrical portions of the gate spacer structure,
wherein the lightly doped regions have different widths that extend along an upper surface of the semiconductor substrate,
wherein outer edges of the lightly doped regions that contact the source region and the drain region are preferably aligned respectively with the outer edges of the two asymmetrical portions of the gate spacer structure.

7. The semiconductor device as claimed in one of the preceding claims, wherein the gate spacer structure comprises:
a first spacer portion overlying the first sidewall of the gate structure, wherein a bottom surface of the first spacer portion has a first width between the source region and the gate structure; and
a second spacer portion overlying the second sidewall of the gate structure, wherein a bottom surface of the second spacer portion has a second width between the drain region and the gate structure,
wherein the second width is greater than the first width,
wherein the semiconductor device preferably further comprises:
a first lightly doped region formed in the semiconductor substrate and beneath the first spacer portion of the gate spacer structure; and
a second lightly doped region formed in the semiconductor substrate and beneath the second spacer portion of the gate spacer structure,
wherein a width of the second lightly doped region between the gate structure and the drain region is greater than a width of the first lightly doped region between the gate structure and the source region,
wherein the first lightly doped region preferably has the first width that extends along an upper surface of the semiconductor substrate, and the second lightly doped region preferably has the second width that extends along the upper surface of the semiconductor substrate.

8. A method of forming a semiconductor device, comprising:
providing a semiconductor substrate having a well region and an isolation structure adjacent to the well region;
forming a gate structure over the well region of the semiconductor substrate, wherein the gate structure has a first sidewall and a second sidewall opposite the first sidewall;
forming a gate spacer structure comprising two asymmetrical portions respectively overlying the first sidewall and the second sidewall of the gate structure; and
forming a source region and a drain region in the semiconductor substrate, wherein the source region and the drain region are aligned with outer edges of the asymmetrical portions of the gate spacer structure,
wherein a lateral distance between the drain region and the gate structure is greater than a lateral distance between the source region and the gate structure.

9. The method of forming the semiconductor device as claimed in claim 8, wherein forming the gate spacer structure comprises:
forming an initial gate spacer layer having symmetrical portions respectively overlying the first sidewall and the second sidewall of the gate structure;
partially removing one of the symmetrical portions that is on the first sidewall of the gate structure,
wherein the other symmetrical portion remains on the second sidewall of the gate structure.

10. The method of forming the semiconductor device as claimed in claim 8 or 9, wherein partially removing one of the symmetrical portions comprises:
providing a patterned mask layer over the semiconductor substrate, wherein the patterned mask layer exposes the symmetrical portion that is on the first sidewall of the gate structure and covers the other symmetrical portion that is on the second sidewall of the gate structure;
selectively etching the symmetrical portion that is on the first sidewall of the gate structure; and
removing the patterned mask layer.

11. The method of forming the semiconductor device as claimed in one of claims 8 to 10, wherein forming the gate spacer structure comprises:
forming an initial gate spacer layer having symmetrical portions respectively overlying the first sidewall and the second sidewall of the gate structure;
removing the symmetrical portion that is on the first sidewall of the gate structure, wherein the first sidewall of the gate structure is exposed, and the other symmetrical portion remains on the second sidewall of the gate structure and is referred to as a remaining initial spacer portion; and
forming a spacer material overlying the exposed first sidewall of the gate structure and overlying the remaining initial spacer portion on the second sidewall of the gate structure,
wherein removing one of the symmetrical portions preferably comprises:
providing a patterned mask layer over the semiconductor substrate, wherein the mask exposes the symmetrical portion that is on the first sidewall of the gate structure and covers the other symmetrical portion that is on the second sidewall of the gate structure;
selectively etching the symmetrical portion that is on the first sidewall of the gate structure; and
removing the patterned mask layer,
wherein the spacer material is formed after the patterned mask layer is removed.

12. The method of forming the semiconductor device as claimed in one of claims 8 to 11, wherein the source region and the drain region are formed by using the gate structure and the asymmetrical portions of the gate spacer structure as an implant mask, and/or
wherein bottom surfaces of the two asymmetrical portions of the gate spacer structure are formed on the well region, and the bottom surface of the asymmetrical portion that is adjacent to the drain region is greater than the bottom surface of the other asymmetrical portion that is adjacent to the source region.

13. The method of forming the semiconductor device as claimed in one of claims 8 to 12, wherein the source region and the drain region are respectively positioned near the first sidewall and the second sidewall of the gate structure,
wherein the gate spacer structure comprises:
a smaller spacer portion between the source region and the first sidewall of the gate structure; and
a larger spacer portion between the drain region and the second sidewall of the gate structure, and/or
wherein the gate spacer structure is made of a single spacer material layer, and the spacer material layer of the two asymmetrical portions of the gate spacer structure respectively overlying the first sidewall and the second sidewall of the gate structure have different bottom widths, and/or
wherein the gate spacer structure is made of multiple spacer material layers, and the two asymmetrical portions of the gate spacer structure respectively overlying the first sidewall and the second sidewall of the gate structure each has a different number of spacer material layers.

14. The method of forming the semiconductor device as claimed in one of claims 8 to 13, further comprising forming lightly doped regions in the semiconductor substrate after the gate structure is formed and before the gate spacer structure is formed,
wherein after the gate spacer structure is formed, the lightly doped regions as formed are respectively beneath the two asymmetrical portions of the gate spacer structure,
wherein after the source region and the drain region are formed, the lightly doped regions preferably have different widths that extend along an upper surface of the semiconductor substrate, or
wherein after the source region and the drain region are formed, outer edges of the lightly doped regions that contact the source region and the drain region are preferably aligned respectively with the outer edges of the two asymmetrical portions of the gate spacer structure.

15. The method of forming the semiconductor device as claimed in one of claims 8 to 14, wherein the gate spacer structure as formed comprises:
a first spacer portion overlying the first sidewall of the gate structure, wherein a bottom surface of the first spacer portion has a first width between the source region and the gate structure; and
a second spacer portion overlying the second sidewall of the gate structure, wherein a bottom surface of the second spacer portion has a second width between the drain region and the gate structure,
wherein the second width is greater than the first width,
wherein before the gate spacer structure is formed, the method preferably further comprises:
forming a first lightly doped region in the semiconductor substrate and adjacent to the first sidewall of the gate structure; and
forming a second lightly doped region in the semiconductor substrate and adjacent to the second sidewall of the gate structure,
wherein after the gate spacer structure is formed, the first spacer portion of the gate spacer structure is formed above the first lightly doped region, and the second spacer portion of the gate spacer structure is formed above the second lightly doped region,
wherein a width of the second lightly doped region between the gate structure and the drain region is preferably greater than a width of the first lightly doped region between the gate structure and the source region, and/or
wherein preferably, the first lightly doped region has the first width that extends along an upper surface of the semiconductor substrate, and the second lightly doped region has the second width that extends along the upper surface of the semiconductor substrate.
